Europäisches Patentamt

(19) European Patent Office

Office européen des brevets

(11) Numéro de publication: **0 035 920**
**B1**

(12) **FASCICULE DE BREVET EUROPEEN**

(45) Date de publication du fascicule du brevet:
20.07.83

(21) Numéro de dépôt: 81400192.1

(22) Date de dépôt: 06.02.81

(51) Int. Cl.³: **H 03 J 5/02, G 01 S 1/46**

(54) Synthétiseur de fréquences, et système de radionavigation comportant un tel synthétiseur.

(30) Priorité: **07.03.80 FR 8005196**

(43) Date de publication de la demande:
**16.09.81 Bulletin 81/37**

(45) Mention de la délivrance du brevet:
**20.07.83 Bulletin 83/29**

(84) Etats contractants désignés:
**BE DE GB IT NL**

(56) Documents cités:
**Wireless World, vol. 83. no. 1503, novembre 1977 Haywards Heath, GB Forrester: «Synthesized f.m. transceiver – 1», pages 84–86
Electrical Communication, vol. 33, no. 1, mars 1956 New York, US Dodington: «Quartz-Crystal Control at 1.000 Megacycles», pages 80–84
IEEE Transactions on Consumer electronics, vol. CE–22, no. 3, Août 1976 New York, US Tickle: «A Low Cost Solution to Digital Tuning of Television Receivers and Citizen Band Transceivers» pages 214–219**

(73) Titulaire: **LMT RADIO PROFESSIONNELLE, 46-47, Quai Alphonse Le Gallo, F-92103 Boulogne-Billancourt (FR)**

(72) Inventeur: **Marchand, Maurice Ernest Léopold, "THOMSON-CSF" - SCPI 173, Bld. Haussmann, F-75360 Paris Cedex 08 (FR)**
Inventeur: **Cassany, Jean-Louis Roger, "THOMSON-CSF" - SCPI 173, Bld. Haussmann, F-75360 Paris Cedex 08 (FR)**

(74) Mandataire: **Desperrier, Jean-Louis et al, THOMSON-CSF SCPI 173, Bld Haussmann, F-75379 Paris Cedex 08 (FR)**

Synthétiseur de fréquences, et système de radionavigation comportant un tel synthétiseur

L'invention concerne un synthétiseur de fréquences destiné au système de radionavigation aérienne TACAN qui est notamment décrit de manière extensive dans Electrical Communication volume 33, Mars 1956.

Dans ce système, les aérionefs comportant des équipements de bord de type TACAN reçoivent à l'aide de balises au sol des informations sous forme de coordonnées polaires.

Ce système fonctionne dans la gamme de fréquences des 1000 MHz et plus précisément dans la bande 962 à 1213 MHz appelée bande TACAN. A l'intérieur de cette bande, la répartition des fréquences d'émission entre les équipements de sol et les équipements de bord varie suivant le mode de fonctionnement.

Pour obtenir les fréquences d'émission, on a d'abord utilisé des oscillateurs à quartz pourvus d'un grand nombre de quartz, par exemple 42 dans l'exemple décrit pages 80 à 84 du document cité ci-dessus. La fréquence de base obtenue était relativement faible et il fallait procéder à plusieurs multiplications de fréquence pour obtenir la fréquence finale. L'ensemble était donc lourd et encombrant.

On sait maintenant produire toute une gamme de fréquence à partir d'un seul quartz avec un dispositif appelé synthétiseur qui comprend un oscillateur contrôlé en tension. Le signal de l'oscillateur est divisé dans un rapport variable par un diviseur puis comparé au signal fourni par le quartz dans un comparateur qui fournit la tension de commande de l'oscillateur. Un tel synthétiseur est par exemple décrit dans la revue Wireless World volume 83, novembre 1977, pages 84 à 86. On remarque toutefois qu'il est là aussi nécessaire de multiplier par 6 (2 × 3) la fréquence obtenue pour obtenir les 144 MHz voulus, ce qui est encore loin des 1000 MHz nécessaires au système TACAN. De plus la sélection des fréquences désirées est faite par une simple conversion des chiffres représentant les canaux en valeurs fixes de rapports de division nécessaires dans des additionneurs bcd (binary coded décimal) et la sélection de mode intervient directement sur le diviseur, indépendamment de cette conversion. Dans le système TACAN le numéro des canaux ne correspond pas de manière bi-univoque à une fréquence déterminée. Celle-ci dépend de l'équipement (sol ou bord) où se trouve l'oscillateur, et du mode (X ou Y) de fonctionnement utilisé. Il n'est donc pas possible de procéder à une simple conversion de chiffres.

L'invention propose donc un synthétiseur de fréquence pour système TACAN dont l'oscillateur contrôlé en tension délivre directement la fréquence désirée. La boîte de commande délivre deux signaux binaires qui définissent le mode et l'équipement utilisés, et le numéro du canal sous la forme de deux fois quatre signaux binaire codant en binaires les chiffres des unités et des dizaines des canaux; Ces différents signaux binaires sont combinés dans un dispositif correcteur qui délivre les signaux binaires de commande du diviseur à rapport variable de la boucle de phase du synthétiseur. Ce diviseur variable est précédé d'un diviseur fixe par 8, ce qui compte tenu d'une fréquence de l'oscillateur de référence égale à 125 kHz, défini les corrections apportées aux signaux du bloc de la commande dans le dispositif correcteur.

D'autres caractéristiques de l'invention ressortiront de la description suivante d'un exemple de réalisation, cette description étant faite en relation avec les dessin ci-annexés dans lesquels:

— la figure 1 représente le plan de répartition des fréquences dans le système TACAN;

— la figure 2 représente schématiquement un synthétiseur de fréquences conforme à l'invention;

— la figure 3 représente de façon détaillée un exemple de réalisation du dispositif correcteur de signaux de commande conforme à l'invention;

— la figure 4 représente un diviseur à rapport variable correspondant au dispositif correcteur de signaux représenté à la figure 3.

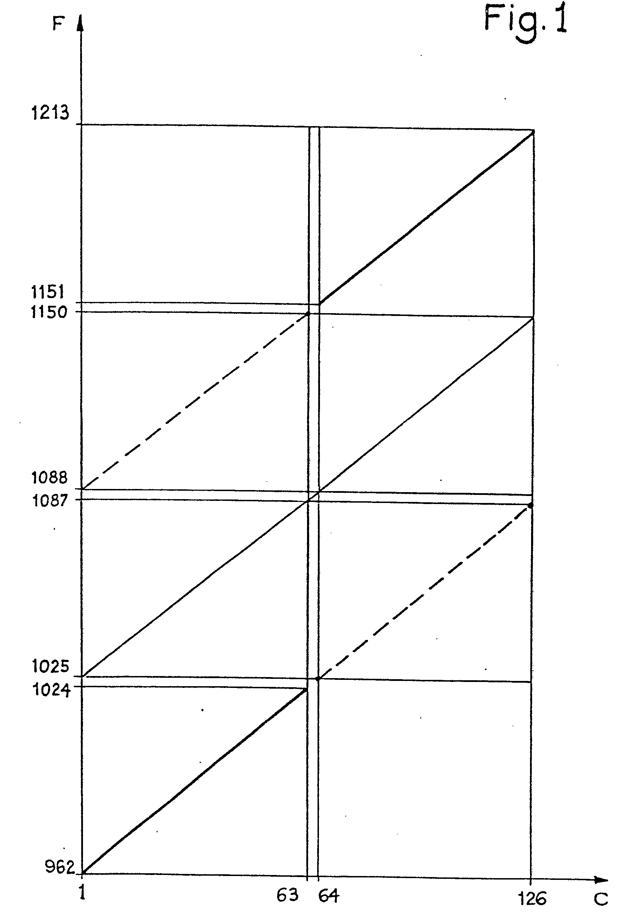

Le plan de répartition des fréquences de la figure 1 donne en abscisse le numéro de canal C qui varie de 1 à 126, et en ordonnée la fréquence exprimée en mégahertz (MHz) qui varie de 962 à 1213, la bande 962 à 1087 MHz étant appelée bande basse et la bande 1088 à 1213 MHz étant appelée bande haute.

Dans le système TACAN, il existe deux principaux modes de fonctionnement: le mode X et le mode Y.

En mode X, les fréquences d'émission des équipements au sol ou «balises» se divisent en une bande basse de 962 à 1024 MHz et une bande haute de 1151 à 1213 MHz, repésentées en traits forts continus sur la figure 1, deux canaux successifs étant séparés de 1 MHz. Les fréquences d'émission des équipements de bord occupent la bande 1025–1150 MHz, représentée en trait fin continu sur la figure 1.

A chaque canal correspond une fréquence d'émission de balise au sol et une fréquence d'émission d'équipement de bord séparées de 63 MHz, la fréquence d'émission de l'un étant la fréquence de réception de l'autre. Par exemple, pour le canal 1X une balise émet sur 962 MHz et reçoit l'émission de l'avion sur 1025 MHz, l'avion reçoit sur 962 MHz et émet sur 1025 MHz.

En mode Y, les fréquence d'émission des équipements au sol se divisent en une bande haute de 1088 à 1150 MHz et une bande basse de 1025 à 1087 MHz, représentées en traits pointillés sur la figure 1. Les fréquences d'émission des équipements de bord sont identiques à celles du mode X.

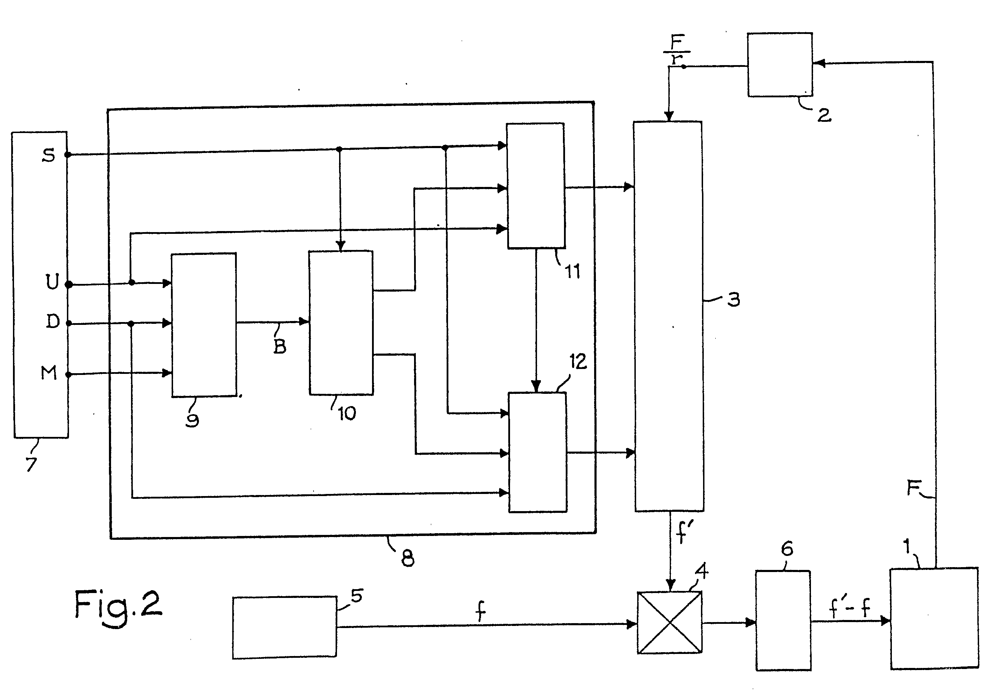

Le synthétiseur de fréquence, conforme à l'invention, représenté à la figure 2 a pour base une boucle à verrouillage de phase.

Il comprend un oscillateur 1 contrôlé en tension dont la sortie fournit un signal à la fréquence d'émission F et est reliée à l'entrée d'un diviseur de fréquence 2 à rapport fixe r, r étant égal à huit dans cet exemple.

La sortie du diviseur 2 fournit un signla de fréquence F/r et est reliée à l'entrée d'un diviseur de fréquence 3 à rapport variable v dont la sortie fournit un signal de fréquence f' égale à $\dfrac{F}{r.v}$ .

La sortie du diviseur 3 est reliée à l'une des entrées d'un comparateur de phase 4 dont l'autre entrée est reliée à la sortie d'un oscillateur 5 de référence qui fournit un signal de fréquence f, et dont la sortie est reliée à l'entrée d'un filtre passe-bas 6. La sortie de ce filtre 6 fournit un signal de fréquence f'–f et est reliée à l'entrée de contrôle en tension de l'oscillateur 1.

Le synthétiseur comporte, enfin, une boîte de commande 7 manipulée par l'opérateur. Elle fournit, tout d'abord, un signal S de sélection qui est au niveau logique «1» si le synthétiseur est utilisé dans un équipement au sol et au niveau logique «0» s'il est utilisé dans un équipement de bord.

Elle fournit ensuite un signal M de sélection de mode, utilisé uniquement pour les équipements au sol, puisque l'on a vu que quel que soit le mode les équipements de bord émettent dans la même bande de fréquence. Ce signal M est à «0» en mode X et à «1» en mode Y.

Enfin, elle fournit deux signaux D et U d'indication de numéro de canal. Le signal U indiquant sur quatre éléments binaires U1, U2, U3 et U4 le chiffre des unités compris entre 0 et 9, et le signal D indiquant sur quatre éléments binaires D1, D2, D3 et D4 le chiffre des dizaines compris entre 0 et 12. Des précautions sont prises pour interdire les états 127, 128 et 129.

Les sorties de la boîte de commande sont reliées aux entrées d'un dispositif 8 correcteur de signaux de commande dont les sorties sont reliées aux entrées de commande du diviseur 3 qui permettent de modifier le rapport v.

Ce dispositif 8 comporte, tout d'abord, un circuit 9 de découpage de bande qui reçoit les signaux M, D et U issus de la boîte de commande et qui fournit un signal B qui est égal à «0» si la fréquence d'émission est en bande basse et à «1» si elle est en bande haute. Il comporte, ensuite, un circuit 10 de traitement des signaux S et B dont les sorties sont reliées pour une partie d'entre elles aux entrées d'un premier additionneur 11 et pour l'autre partie aux entrées d'un second additionneur 12.

L'additionneur 11 reçoit également les signaux S et U et l'additionneur 12 les signaux S et D. Les sorties des additionneurs sont reliées aux entrées de commande du diviseur 3 auxquelles ils fournissent des signaux corrigés.

Pour pouvoir émettre correctement, il faut que, lorsque l'opérateur affiche un type d'utilisation par S, un mode de fonctionnement par M et un canal par D et U, et lorsque la boucle est verrouillée, la fréquence F soit celle indiquée par le plan de la figure 1.

La boucle est verrouillée, lorsque f'–f est nul, c'est-à-dire lorsque $f = f' = \dfrac{F}{r.v}$ ; dans notre exemple f est égal à 125 kHz et r à 8, cela signifie donc que F/v est égal à 1 MHz et comme F varie de 962 MHz à 1213 MHz, v doit varier de 962 à 1213.

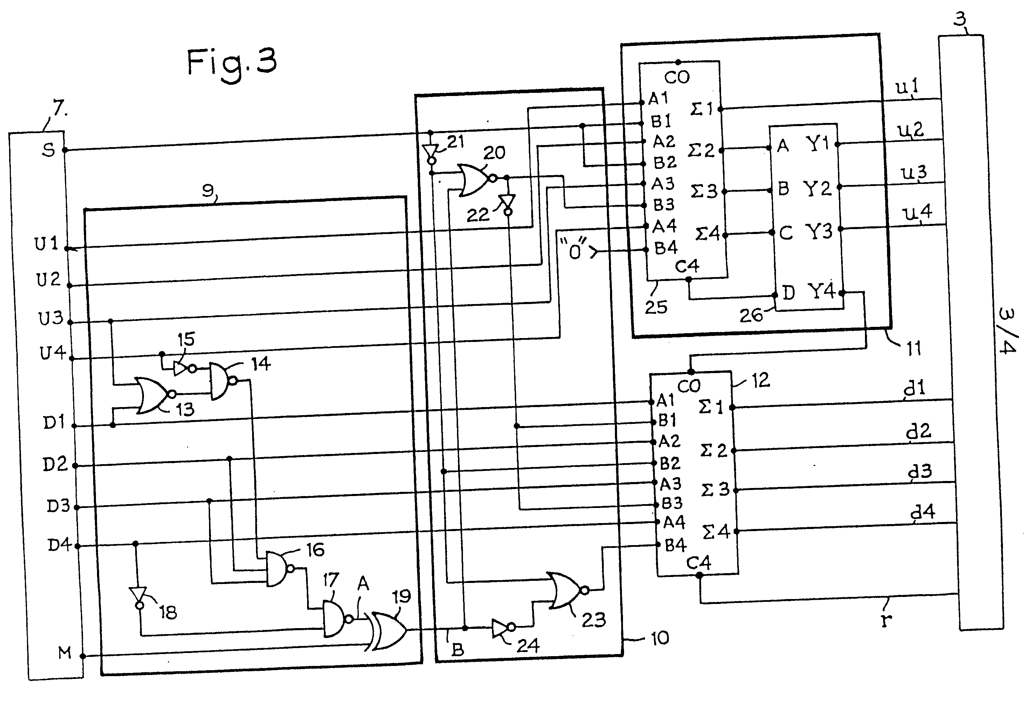

La correspondance entre l'affichage par l'opérateur et la commande du rapport v du diviseur 3 en accord avec le plan de répartition de la figure 1 est effectué par le dispositif 8, qui est représenté de façon détaillée à la figure 3.

Le circuit 9 de découpage de bande comporte une porte logique «NON OU» 13 qui reçoit les signaux U3 et D1 et dont la sortie est reliée à l'une des entrées d'une porte logique «NON ET» 14. L'autre entrée de la porte «NON ET» 14 reçoit l'inverse du signal U4 ou $\overline{U4}$ issu d'in inverseur 15 et la sortie 14 est reliée à l'une des trois entrées d'une porte logique «NON ET» 16 dont les deux autres entrés reçoivent respectivement les signaux D2 et D3. La sortie de la porte 16 est reliée à l'une des entrées d'une porte logique «NON ET» 17 dont l'autre entrée reçoit l'inverse du signal D4 ou $\overline{D4}$ issu d'un inverseur 18.

Le signal A issu de la porte 17 est au niveau logique «0» si le nombre affiché par D et U est inférieur ou égal à 63 et à «1» si ce nombre est supérieur 63.

Le circuit 9 comporte, enfin, une porte logique «OU EXCLUSIF» 19 dont les entrées reçoivent les signaux A et M et dont la sortie fournit le signal B qui est à «0» en bande basse et à «1» en bande haute.

Le circuit 10 de traitement des signaux S et B comporte une porte logique «NON OU» 20 dont l'une des entrées reçoit le signal B et dont l'autre reçoit l'inverse du signal S ou $\overline{S}$ issu d'un inverseur 21. Il comporte également un inverseur 22 dont l'entrée est reliée à la sortie de la porte logique 20, et une porte logique «NON OU» 23 dont l'une des entrées reçoit le signal $\overline{S}$ issu de la porte 21 et dont l'autre entrée reçoit l'inverse du signal B ou $\overline{B}$ issu d'in inverseur 24.

Ce circuit 10 élabore, sous forme de quatre éléments binaires pour les unités et quatre éléments binaires pour les dizaines, les nombres à additionner à ceux affichés par l'opérateur afin de commander correctement le diviseur 3.

Par exemple, en équipement de sol, si l'opérateur affiche le canal 1X la fréquence F doit être égale à 962 MHz et v doit être égal à 962, par contre s'il affiche 1Y la fréquence F doit être égale à 1088 MHz et v doit être égal à 1088.

Si n est le nombre correcteur choisi pour des équipements au sol en bande basse, le nombre correcteur pour des équipements au sol en bande haute est égal à n+126 et le nombre correcteur pour des équipements de bord est égal à n+63.

Mais la réalisation du circuit 10 est très étroitement liée à la réalisation du diviseur 3 à rapport variable; en effet, les nombres à additionner sont choisis de façon à obtenir en entrée et en sortie du diviseur 3 des circuits logiques les plus simples possibles.

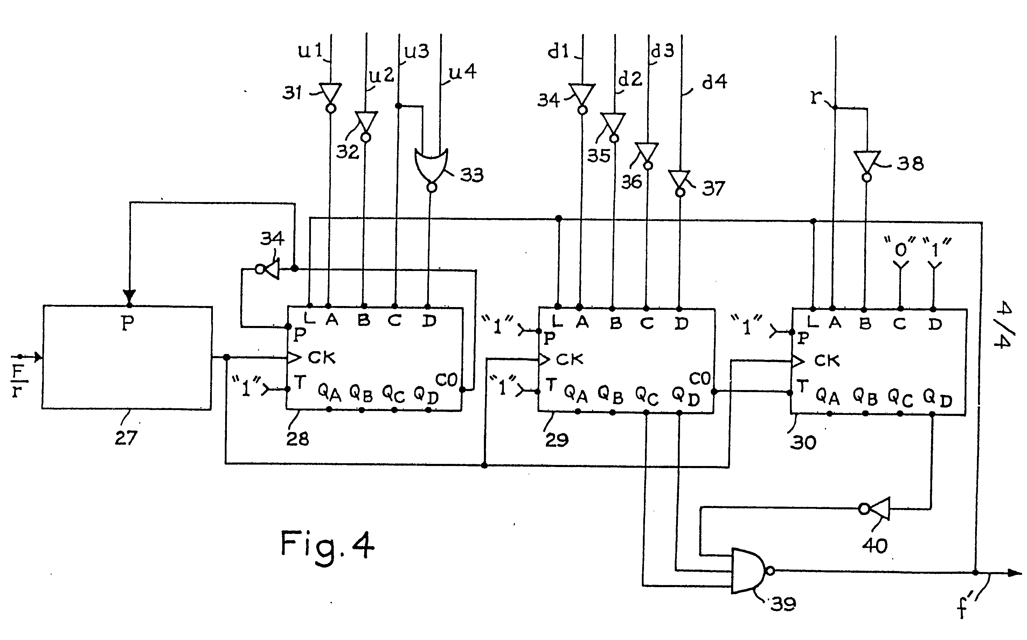

La réalisation du circuit 10, représentée à la figure 3 et associée au diviseur 3 représenté à la figure 4 correspond à n égal à 7, c'est-à-dire à l'addition des nombres suivants:

07 pour des équipements au sol en bande basse 133 pour des équipements au sol en bande haute

70 pour des équipements de bord.

Le premier additionner 11 est constitué par un additionneur 25 binaire de deux nombres de quatre éléments binaire chacun et par un convertisseur 26 de code binaire en code BCD (décimal codé binaire). Le premier nombre correspondant au chiffre des unités affiché par l'opérateur, les entrées A1, A2, A3 et A4 de l'additionneur 25 reçoivent respectivement les signaux U1, U2, U3 et U4, et le second nombre correspondant au chiffre des unités des nombres définis ci-dessus, les entrées B1 et B2 de 25 reçoivent le signal S, l'entrée B3 de 25 reçoit le signal issu de la porte «NON OU» 20 et l'entrée B4 de 25 est au niveau logique «0».

La seconde sortie $\Sigma 2$ de l'additionneur 25 est reliée à la première entrée A du convertisseur 26, la troisième sortie $\Sigma 3$ de l'additionneur 25 est reliée à la deuxième entrée B du convertisseur 26, la quatrième sortie $\Sigma 4$ de l'additionneur 25 est reliée à la troisième entrée C du convertisseur 26 de la sortie de retenue C4 de l'additionneur 25 est reliée à la quatrième entrée D du convertisseur 26.

La première sortie $\Sigma 1$ de l'additionneur 25 et les trois premières sorties Y1, Y2, Y3 du convertisseur 26 sont reliées à une première partie des entrées de commande du diviseur 3 à rapport variable auxquelles elles fournissent respectivement les signaux d'unités corrigés u1, u2, u3 et u4.

Le second additionneur 12 est un additionneur binaire de deux nombres de quatre éléments binaires. Le premier nombre correspondant au chiffre des dizaines affiché par l'opérateur, les entrées A1, A2, A3 et A4 de l'additionneur 12 reçoivent respectivement les signaux D1, D2, D3 et D4, et le second nombre correspondant au chiffre des dizaines des nombres définis ci-dessus, les entrées B1 et B3 de 12 reçoivent le signal issu de l'inverseur 22, l'entrée B2 de 12 reçoit le signal $\overline{S}$ issu de l'inverseur 21, et l'entrée B4 de 12 reçoit le signal issu de la porte «NON OU» 23, l'entrée de retenue CO de 12 étant reliée à la quatrième sortie Y4 du convertisseur 26.

Les quatres sorties $\Sigma 1$, $\Sigma 2$, $\Sigma 3$, $\Sigma 4$ et la sortie de retenue C4 de l'additionneur 12 sont reliées à une seconde partie des entrées de commande du diviseur 3 à rapport variable auxquelles elles fournissent respectivement les signaux de dizaines corrigés d1, d2, d3, d4 et le signal de retenue r.

A la figure 4, on a représenté une réalisation détaillée du diviseur de fréquence 3 à rapport variable auquel est associé le circuit correcteur 8 représenté à la figure 3.

Ce diviseur comporte un diviseur de fréquence 27 à deux rapports fixes (dix et onze), trois compteurs 28, 29, 30 synchrones à quatre éléments binaires et des circuits logiques en entrée et en sortie de ces compteurs.

Le diviseur de fréquence 27 reçoit le signal de fréquence F/r issu du diviseur 2 et il fournit un signal de fréquence $\dfrac{F}{10.2}$ quand son entrée P de commande est au niveau logique «1» et un signal de fréquence $\dfrac{F}{11.2}$ quand elle est au niveau logique «0». La sortie du diviseur 27 est reliée à l'entrée d'horloge CK de chacun des compteurs 28, 29 et 30.

L'entrée A du compteur 28 reçoit l'inverse du signal u1 ou $\overline{u1}$ issu d'un inverseur 31, l'entrée B l'inverse du signal u2 ou $\overline{u2}$ issu d'un inverseur 32, l'entrée C le signal u3 et l'entrée D le signal issu d'une porte «NON OU» 33 dont les entrées reçoivent les signaux u3 et u4. L'entrée T de validation de comptage du compteur 28 est au niveau logique «1», l'entrée P de validation de comptage 28 est reliée à la sortie d'in inverseur 34 dont l'entrée est reliée à la sortie CO de retenue de ce même compteur 28, cette sortie CO étant également reliée à l'entrée P de commande du diviseur 27.

Les entrées A, B, C, D du compteur 29 reçoivent respectivement les signaux $\overline{d1}$, $\overline{d2}$, $\overline{d3}$ et $\overline{d4}$ issus respectivement des inverseurs 34, 35, 36, 37 dont les entrées reçoivent respectivement les signaux d1, d2, d3, d4. Les entrées de validation P et T du compteur 29 sont au niveau logique «1» en permanence, c'est-à-dire qu'elles ne sont pas utilisées.

La sortie CO de retenue du compteur 29 est reliée à l'entrée T de validation de compatge du compteur 30 dont l'autre entrée P de validation est au niveau logique «1». L'entrée A du compteur 30 reçoit le signal r et l'entrée B reçoit le signal $\overline{r}$ issu d'un inverseur 38 dont l'entrée reçoit le signal r. L'entrée C est au niveau logique «0» et l'entrée D au niveau logique «1».

En sortie, le diviseur de fréquence à rapport variable comporte une porte logique «NON ET» 39 à trois entrées, dont deux entrées sont reliées respectivement aux sorties QC et QD du compteur 29 et dont la troisième entrée est reliée à la sortie d'un inverseur 40 ayant son entrée reliée à la sortie QD du compteur 30.

La sortie de la porte «NON ET» 39, qui fournit le signal de fréquence f' égale à $\dfrac{F}{r.v}$ est reliée d'une part aux entrées L de chargement des compteurs 28, 29 et 30, et d'autre part au comparateur de phase 4.

Ce diviseur à rapport variable v compris entre 962 et 1213 utilise la décomposition du nombre v en somme d'un multiple de dix et d'un multiple de onze. Par exemple:

$$962 = 96 \times 10 + 2(11-10) = 94 \times 10 + 2 \times 11.$$

## Revendications

1. Synthétiseur de fréquences pour système TACAN comportant un oscillateur contrôlé en tension (1), un diviseur de fréquence (2) à rapport fixe r dont l'entrée est reliée à la sortie de l'oscillateur contrôlé en tension (1), un diviseur de fréquence (3) à rapport variable v dont l'entrée est reliée à la sortie du diviseur de fréquence (2) à rapport fixe, une boîte de commande (7) qui permet de commander le diviseur à rapport variable (3) par l'intermédiaire d'un dispositif correcteur de signaux de commande (8), un comparateur de phase (4) dont l'une des entrées est reliée à la sortie du diviseur (3) à rapport variable, un oscillateur de référence (5) dont la sortie est reliée à l'autre entrée du comparateur de phase (4) dont la sortie est reliée via un filtre passe-bas (6) à l'entrée de contrôle de l'oscillateur contrôlé en tension (1), caractérisé en ce que l'oscillateur contrôlé en tension (1) fournit directement la fréquence TACAN (F), que la boîte de commande (7) fournit un premier signal (S) formé d'un chiffre binaire indiquant le type d'équipement (sol ou bord) dans lequel est monté le synthétiseur q̄ui est identique pour ces deux équipements, un deuxième signal (M) formé d'un chiffre binaire indiquant le mode de fonctionnement (X ou Y) sélectionné, et deux signaux (U et D) de sélection d'un canal parmi 126 formés d'un premier nombre de quatre chiffres binaires (U1, U2, U3, U4) donnant le chiffre des unités et d'un deuxième nombre de quatre chiffres binaires (D1, D2, D3, D4) donnant le chiffre de dizaines, que le rapport fixe r est égal à 8, que la fréquence (f) de référence est égale à 125 kHz, que le rapport variable v est compris entre 962 et 1213, et que le dispositif correcteur (8) permet d'additionner aux deux signaux (U et D) de sélection des signaux correcteurs représentant en binaire un nombre égal à:

– 07 quand le premier (S) et le deuxième (M) signal indiquent que le synthétiseur est monté dans un équipement au sol utilisé en bande basse;

– 133 quand le premier (S) et le deuxième (M) signal indiquent que le synthétiseur est monté dans un équipement au sol utilisé en bande haute;

– 70 quand le premier (S) et le deuxième (M) signal indiquent que le synthétiseur est monté dans un équipement de bord.

2. Synthétiseur selon la revendication 1, caractérisé en ce que le dispositif correcteur (8) comporte:

– un circuit (9) de découpage de bande dont les entrées reçoivent le deuxième signal (M) et les deux signaux (U et D) de sélection de canal, et dont la sortie fournit un signal (B) d'indication de bande basse ou haute;

– un circuit de traitement (10) du premier signal (S) et du signal (B) d'indication de bande, dont les sorties fournissent les signaux correcteurs formés de deux nombres correcteurs, le premier pour les unités, le second pour les dizaines, codés chacun sur quatre éléments binaires;

– un premier circuit additionneur (11) qui reçoit le premier nombre (U1, U2, U3, U4) de la boîte de commande (7) et le premier nombre correcteur, et qui fournit des signaux (u1, u2, u3, u4) d'unités corrigées à une première partie des entrées du diviseur (3) à rapport variable;

– un second circuit additionneur (12) qui reçoit le deuxième nombre (D1, D2, D3, D4) de la boîte de commande (7), le deuxième nombre correcteur, et un signal de retenue issu du premier circuit additionner (11), et qui fournit des signaux (d1, d2, d3, d4) de dizaines corrigées et un signal (r) de retenue à une seconde partie des entrées du diviseut (3) à rapport variable et que le diviseur à support variable (3) est constitué par:

– un diviseur de fréquence (27) à deux rapports fixes (dix et onze) dont l'entrée est reliée à la sortie du diviseur (3) à rapport fixe,

– un premier compteur (28) synchrone à quatre éléments binaires dont l'entrée d'horloge est reliée à la sortie du diviseur de fréquence (27) à deux rapports fixes, dont l'entrée A reçoit le signal (u̅1̅) issu d'un premier inverseur (31) qui reçoit le premier signal (u1) d'unité corrigée issu du dispositif (8) correcteur, dont l'entrée B reçoit le signal (u̅2̅) issu d'un second inverseur (32) qui reçoit le second signal (u2) d'unité corrigée, dont l'entrée C reçoit le troisième signal (u3) d'unité corrigée, dont l'entrée D reçoit le signal issu d'une porte logique «NON OU» (33) dont les entrées reçoivent respectivement le troisième (u3) et le quatrième (u4) signal d'unité corrigée, et dont l'entrée (P) de validation de comptage est reliée à la sortie de retenue CO via un troisième inverseur (34), la sortie de retenue CO étant également reliée à l'entrée (P de commande du rapport du diviseur de fréquence (27) à deux rapports fixes,

– un second compteur (29) dont l'entrée d'horloge est reliée à la sortie du diviseur de fréquence (27) à deux rapports fixes, dont les entrées A, B, C, D reçoivent respectivement les signaux (d̅1̅, d̅2̅, d̅3̅, d̅4̅) issus respectivement de quatrième, cinquième, sixième et septième (34, 35, 36, 37) inverseurs dont les entrées reçoivent les signaux (d1, d2, d3, d4) de dizaines corrigées issus du dispsoitif (8) correcteur,

– un troisième compteur (30) dont l'entrée d'horloge est reliée à la sortie du diviseur de fréquence (27) à deux rapports fixes, dont l'entrée A reçoit le signal (r) de retenue issu du dispositif (8) correcteur, dont l'entrée B reçoit le signal (r̅) issu d'un huitième inverseur (40) dont l'entrée reçoit le signal (r), dont l'entrée C est au niveau logique «0», dont l'entrée D est au niveau logique «1» et dont l'entrée T de validation de comptage est reliée à la sortie CO de retenue du deuxième compteur (29),

– une porte logique «NON ET» 39 à trois entrées dont deux entrées sont reliées respectivement aux sorties QC et QD du deuxième compteur (29), dont la troisième entrée est reliée à la sortie d'un neuvième inverseur (40) dont l'entrée est reliée à la sortie QD du troisième compteur (30), et dont la sortie est reliée d'une part à l'entrée L de chargement de chacun des trois compteurs (28, 29, 30) et d'autre part au comparateur de phase (4).

3. Synthétiseur de fréquence selon la revendication 2, caractérisé en ce que le circuit de découpage de bande (9) comporte:

– une porte logique «NON OU» (13) dont une entrée reçoit le signal U3 et l'autre entrée le signal D1,

– une première porte logique «NON ET» (14) dont une entrée est reliée à la sortie de la porte logique «NON OU» et dont l'autre entrée est reliée à la sortie d'un premier inverseur (15) qui reçoit le signal U4,

– une deuxième porte logique «NON ET» (16) à trois entrées dont une entrée est reliée à la sortie de la première porte «NON ET» (14) et dont les deux autres entrées reçoivent respectivement les signaux D1 et D3,

– une troisième porte logique «NON ET» (17) dont une entrée est reliée à la sortie de la deuxième porte «NON ET» (16) et dont l'autre entrée est reliée à la sortie d'un second inverseur (18) qui reçoit le signal D4,

– une porte logique «OU EXCLUSIF» (19) dont une entrée est reliée à la sortie de la troisième porte «NON ET» (17) dont l'autre entrée reçoit le deuxième signal (M) d'indication de mode de fonctionement et dont la sortie fournit le signal (B) d'indication de bande.

4. Synthétiseur de fréquences selon la revendication 3 caractérisé en ce que le circuit de traitement (10) comporte:

– un premier inverseur (21) dont l'entrée reçoit le premier signal (S) d'indication de type d'utilisation,

– une première porte «NON OU» (20) dont l'une des entrées est reliée à la sortie du premier inverseur et dont l'autre entrée est reliée à la sortie du circuit de découpage de bande,

– un deuxième inverseur (22) dont l'entrée est reliée à la sortie de la première porte «NON OU» (20),

– un troisième inverseur (24) dont l'entrée est reliée à la sortie du circuit de découpage de bande,

– une seconde porte «NON OU» (23) dont une entrée est reliée à la sortie du premier inverseur (21) et dont l'autre entrée est reliée à la sortie du troisième inverseur (24),

en ce que le premier circuit additionneur (11) est constitué par:

– un additionneur (25) binaire de deux nombres de quatre éléments binaires dont les entrées, A1, A2, A3, A4 reçoivent respectivement les signaux U1, U2, U3, U4 dont les entrées B1 et B2 reçoivent le signal (S) d'indication de type d'utilisation, dont l'entrée B3 reçoit le signal issu de la première porte «NON OU» (20) du circuit de traitement et dont l'entrée B4 est au niveau logique «0».

– un convertisseur (26) de code binaire en code «BCD» dont les première, deuxième et troisième entrées sont reliées respectivement aux deuxième, troisième et quatrième sorties de l'additionneur (25), dont la quatrième entrée est reliée à la sortie de retenue de cet additionneur (25) et dont les première, deuxième et troisième sorties fornissent respectivement les deuxième (u2), troisième (u3) et quatrième (u4) signaux d'unités corrigées, le premier (u1) étant fourni directement par la première sortie de l'additonneur (25),

et en ce que le second circuit additionneur (12) est constitué par un additionneur (12) binaire de deux nombres de quatre éléments binaires dont les entrées A1, A2, A3, A4 reçoivent respectivement les signaux D1, D2, D3, D4, dont les entrées B1 et B3 reçoivent le signal issu du deuxième inverseur (22) du circuit de traitement (10), dont l'entrée B2 reçoit le signal issu du premier inverseur (21) du circuit de traitement (10) dont l'entrée B4 reçoit le signal issu de la seconde porte «NON OU» (23) de ce même circuit de traitement (10), dont l'entrée de retenue CO est reliée à la quatrième sortie du convertisseur (26) de code binaire en code «BCD» et dont les quatre sorties fournissent les signaux (d1, d2, d3, d4) de dizaines corrigées, le signal (r) de retenue étant fourni par la sortie C4 de retenue de cet additionneur (12).

**Patentansprüche**

1. Frequenzsynthetisierer für das TACAN System, mit einem spannungsgesteuerten Oszillator (1), einem Frequenzteiler (2), der ein festes Teilerverhältnis r besitzt und dessen Eingang an den Ausgang des spannungsgesteuerten Oszillators (1) angeschlossen ist, mit einem Frequenzteiler (3), der ein variables Teilerverhältnis v besitzt und dessen Eingang an den Ausgang des Frequenzteilers (2) mit festem Teilerverhältnis angeschlossen ist, mit einer Steuereinheit (7), die in der Lage ist, den Teiler mit variablem Teilerverhältnis (3) über eine Korrekturvorrichtung (8) für Steuersignale zu steuern, mit einem Phasenvergleicher (4), von dem ein Eingang an den Ausgang des Teilers (3) mit variablem Teilerverhältnis angeschlossen ist, mit einem Referenzoszillator (5), dessen Ausgang an den anderen Eingang des Phasenvergleichers (4) angeschlossen ist, wobei der Ausgang des Phasenvergleichers über ein Tiefpassfilter (6) an den Steuereingang des spannungsgesteuerten Oszillators (1) angeschlossen ist, dadurch gekennzeichnet, dass der spannungsgesteuerte Oszillator (1) direkt die TACAN-Frequenz (F) liefert, dass die Steuereinheit (7) ein erstes Signal (S), das aus einer den Gerätetyp (am Boden oder an Bord), in dem der für beide Geräte identische Synthetisierer eingebaut ist, anzeigenden Binärziffer gebildet wird, ein zweites Signal (M), das aus einer die gewählte Betriebsart (X oder Y) angebenden Binärziffer gebildet wird, und zwei Signale (U und D) liefert, die die Auswahl eines aus 126 Kanälen bewirken und aus einer ersten Zahl mit vier Binärziffern (U1, U2, U3, U4), die die Einheitenziffern wiedergeben, und aus einer zweiten Zahl von vier Binärziffern (D1, D2, D3, D4) gebildet werden, die die Zehnerziffern wiedergibt, dass das feste Teilerverhältnis r gleich 8 ist, dass die Referenzfrequenz (f), gleich 125 kHz ist, dass das variable Teilerverhältnis v zwischen 962 und 1213 liegt und dass die Korrekturvorrichtung (8) in der Lage ist, zu den beiden Selektionssignalen (U und D) Korrektursignale hinzuzuaddieren, die binär eine Zahl wiedergeben, die gleich ist

– 07, wenn das erste (S) und das zweite Signal (M) angeben, dass der Synthetisierer in einem Bodengerät eingebaut ist, das im tieferen Frequenzband verwendet wird;

– 133, wenn das erste (S) und das zweite Signal (M) anzeigen, dass der Synthetisierer in einem Bodengerät eingebaut ist, das im höheren Frequenzband verwendet wird;

– 70, wenn das erste (S) und das zweite Signal (M) anzeigen, dass der Senthetisierer in einem Bodengerät eingebaut ist.

2. Synthetisierer nach Anspruch 1, dadurch gekennzeichnet, dass die Korrekturvorrichtung (8) aufweist:

– einen Bandtrennschaltkreis (9), dessen Eingänge das zweite Signal (M) und die beiden Signale (U und D) zur Auswahl des Kanals zugeführt erhalten und dessen Ausgang ein Signal (B) zur Anzeige des niedrigeren oder höheren Frequenzbandes liefert;

– einen Bearbeitungsschaltkreis (10) für das erste Signal (S) und das Bandanzeigesignal (B), dessen Ausgänge die Korrektursignale liefern, die von zwei Korrekturzahlen, die erste für die Einheiten und die zweite für die Zehner, je in vier Bits verschlüsselt, gebildet werden;

– einen ersten Addierschaltkreis (11), der die erste Zahl (U1, U2, U3, U4) der Steuereinheit (7) und die erste Korrekturzahl zugeführt erhält und die korrigierten Signale (u1, u2, u3, u4) des Einheitenwertes an einen ersten Teil der Eingänge des Teilers (3) mit variablem Teilerverhältnis liefert;

– einen zweiten Addierschaltkreis (12), der die zweite Zahl (D1, D2, D3, D4) der Steuereinheit (7), die zweite Korrekturzahl und ein Übertragssignal zugeführt erhält, das vom ersten Addierschaltkreis (11) ausgeht, und der die korrigierten Zehnerstellensignale (d1, d2, d3, d4) und ein Übertragungssignal (r) einem zweiten Teil der Eingänge des Teilers (3) mit variablem Teilerverhältnis zuführt;

und dass der Teiler (3) mit variablem Teilerverhältnis besteht aus:

– einem Frequenzteiler (27) mit zwei festen Teilerverhältnissen (zehn und elf), dessen Eingang an den Ausgang des Teilers (3) mit festem Teilerverhältnis angeschlossen ist,

– einem ersten synchronen Zähler (28) mit vier Binärelementen, dessen Takteingang an den Ausgang des Frequenzteilers (27) mit zwei festen Teilerverhältnissen angeschlossen ist, dessen Eingang A das von einem ersten Inverter (31) ausgehende Signal ($\overline{u1}$) zugeführt erhält, der seinerseits das erste von der Korrekturvorrichtung (8) ausgehende korrigierte Signal (u1) der Einheitenstelle zugeführt erhält, dessen Eingang B das von einem zweiten Inverter (32) ausgehende Signal ($\overline{u2}$) zugeführt erhält, der seinerseit das zweite korrigierte Signal (u2) der Einheitenstelle zugeführt erhält, dessen Eingang C das dritte korrigierte Signal (u3) der Einheitenstelle zugeführt erhält, dessen Eingang D das von einem logischen NICHT-ODER-Tor (33) ausgehende Signal zugeführt erhält, wobei die Eingänge dieses Tores das dritte (u3) bzw. das vierte korrigierte Signal der Einheitenstelle (u4) zugeführt erhalten, und wobei der Zählsteuereingang (P) an den Übertragungsausgang CO über einen dritten Inverter (34) angeschlossen ist und der Übertragungsausgang CO ebenfalls an den Steuereingang (P) für das Teilverhältnis des Frequenzteilers (27) mit festen Teilerverhältnissen angeschlossen ist,

– einem zweiten Zähler (29), dessen Takteingang an den Ausgang des Frequenzteilers (27) mit zwei festen Teilerverhältnissen angeschlossen ist, dessen Eingänge A, B, C bzw. D mit dem von einem vierten, fünften, sechsten bzw. siebten Inverter (34, 35, 36, 37) stammenden Signalen ($\overline{d1}$, $\overline{d2}$, $\overline{d3}$, $\overline{d4}$) gespeist werden, wobei die Eingänge dieser Inverter die korrigierten, von der Korrekturvorrichtung (8) ausgehenden Signale der Zehnerstelle zugeführt erhalten,

– einem dritten Zähler (30), dessen Takteingang an den Ausgang des Frequenzteilers (27) mit zwei festen Teilerverhältnissen angeschlossen ist, wobei der Eingang A dieses Frequenzteilers das Übertragssignal (r) von der Korrekturvorrichtung (8) zugeführt erhält, der Eingang B das Ausgangssignal ($\overline{r}$) eines achten Inverters (40) zugeführt erhält, an dessen Eingang das Signal (r) anliegt, der Eingang C auf dem logischen Pegel «0» liegt, der Eingang D auf dem logischen Pegel «1» liegt und der Zählsteuereingang T mit dem Übertragungsausgang CO des zweiten Zählers (29) verbunden ist,

– einem logischen «NICHT-UND»-Tor 39 mit drei Eingängen, von denen zwei mit dem Ausgang QC bzw. QD des zweiten Zählers (29) und der dritte Eingang mit dem Ausgang eines neunten Inverters (40) verbunden sind, dessen Eingang an den Ausgang QD des dritten Zählers (30) angeschlossen ist und dessen Ausgang einerseits mit dem Ladeeingang L jedes der drei Zähler (28, 29, 30) und andererseits mit dem Phasenvergleicher (4) verbunden ist.

3. Frequenzsynthetisierer nach Anspruch 2, dadurch gekennzeichnet, dass der Bandtrennschaltkreis (9) aufweist:

– ein logisches «NICHT-ODER»-Tor 13, dessen einer Eingang das Signal U3 und dessen anderer Eingang das Signal D1 empfängt.

– ein erstes logisches «NICHT-UND»-Tor (14), dessen einer Eingang mit dem Ausgang des logischen «NICHT-ODER»-Tors und dessen anderer Eingang mit dem Ausgang eines ersten das Signal U4 empfangenden Inverters (15) verbunden ist,

– ein zweites logisches «NICHT-UND»-Tor (16) mit drei Eingängen, von denen einer mit dem Ausgang des ersten «NICHT-UND»Tors (14) verbunden ist und dessen beide andere Eingänge das Signal D1 bzw. das Signal D3 empfangen,

– ein drittes logisches «NICHT-UND»-Tor (17), von dem ein Eingang mit dem Ausgang des zweiten «NICHT-UND»-Tors (16) und der andere mit dem Ausgang eines zweiten, das Signal D4 empfangenden Inverters (18) verbunden ist,

– ein logisches «EXKLUSIV-ODER»-Tor (19), von dem ein Eingang mit dem Ausgang des dritten «NICHT-UND»-Tors (17) und der andere mit dem zweiten, die Betriebsart anzeigenden Signal (M) verbunden ist, während der Ausgang das Frequenzband-Anzeigesignal (B) liefert.

4. Frequenzsynthetisierer nach Anspruch 3, dadurch gekennzeichnet, dass der Behandlungsschaltkreis (10) umfasst:

– einen ersten Inverter (21), dessen Eingang das erste die Verwendungsart anzeigende Signal (S) empfängt,

– ein erstes «NICHT-ODER»-Tor (20), dessen einer Eingang mit dem Ausgang des ersten Inverters und dessen anderer Eingang mit dem Ausgang des Bandtrennschaltkreises verbunden ist,

– einen zweiten Inverter (22), dessen Eingang mit dem Ausgang des ersten «NICHT-ODER»-Tors (20) verbunden ist,

– einen dritten Inverter (24), dessen Eingang mit dem Ausgang des Bandtrennschaltkreises verbunden ist,

– ein zweites «NICHT-ODER»-Tor (23), dessen einer Eingang an den Ausgang des ersten Inverters (21) und dessen anderer Eingang an den Ausgang des dritten Inverters (24) angeschlossen ist, dass der erste Addierschaltkreis (11) besteht aus:

– einem Binäraddierer (25) zur Addition zweier aus je vier Binärelementen bestehender Zahlen, dessen Eingänge A1, A2, A3, A4 die Signale U1, U2, U3, U4 zugeführt erhalten, während die Eingänge B1 und B2 das die Verwendungsart anzeigende Signal (S), der Eingang B3 das von dem ersten «NICHT-ODER»-Tor (20) des Behandlungsschaltkreises stammende Signal und der Eingang B4 den logischen Pegel «0» zugeführt erhalten,

– einem Kodewandler (26) vom Binärkode zum BCD-Kode, dessen erster bzw. zweiter bzw. dritter Eingang an den zweiten, dritten, vierten Ausgang des Addierers (25) angeschlossen sind, während der vierte Eingang an den Übertragungsausgang dieses Addierers (25) angeschlossen sind und dessen erster, zweiter und dritter Ausgang das zweite (u2), dritte (u3) bzw. vierte (u4) korrigierte Signal der Einheitenstelle liefert, während das erste Signal (u1) direkt vom ersten Ausgang des Addierers (25) geliefert wird,

und dass der zweite Addierschaltkreis (12) aus einem Binäraddierer (12) zur Addition zweier aus je vier Binärelementen bestehender Zahlen besteht, dessen Eingänge A1, A2, A3, A4 die Signale D1, D2, D3 bzw. D4 zugeführt erhalten, dessen Eingänge B1 und B3 das vom zweiten Inverter (22) des Behandlungsschaltkreises (10) stammende Signal empfangen, dessen Eingang B2 das vom ersten Inverter (21) des Behandlungsschaltkreises (10) stammende Signal zugeführt erhält, dessen Eingang B4 das vom zweiten «NICHT-ODER»-Tor (23) dieses selben Behandlungsschaltkreises (10) stammende Signal zugeführt erhält, dessen Übertragseingang CO mit dem vierten Ausgang des Kodekonverters (26) zur Umwandlung des Binärkodes in den BCD-Kode verbunden ist und dessen vier Ausgänge die korrigierten Zehnersignale (d1, d2, d3, d4) liefern, während das Übertragungssignal (r) vom Übertragsausgang C4 dieses Addierers (12) geliefert wird.

**Claims**

1. Frequency syntheziser for a TACAN system comprising a voltage controlled oscillator (1), a frequency divider (2) having a fixed division rate and having its input connected to the output of the voltage controlled oscillator (1), a frequency divider with variable division rate v, the input of which is connected to the output of the frequency divider (2) having a fixed rate, a control unit (7) which is able to control the variable rate divider (3) via a control signal correction device (8), a phase comparator (4), one input of which is connected to the output of the variable rate divider, a reference oscillator (5), the output of which is connected to the other input of the phase comparator, the output of the latter being connected via a low pass filter (6), to the control input of the voltage controlled oscillator (1), characterized in that the voltage controlled oscillator (1) directly furnishes the TACAN frequency (F), that the control unit (7) furnishes a first signal (S) constituted by a binary digit which indicates the type of equipment (earth or bord) in which the indicator which is identical for both equipments is mounted, a second signal (M) constituted by a binary digit indicating the selected operation mode (X or Y) and two signals (U and D) for selecting one channel out of 125 channels, constituted by a first number having four binary digits (U1, U2, U3, U4) giving the units digits, and a second number having four binary digits (D1, D2, D3, D4) giving the decimal digit, that the fixed rate r is equal to 8, that the reference frequency (f) is equal to 125 kilo-cycles per second, that the variable rate v is included between 962 and 1213 and that the correction device (8) is able to add to the two selection signals (U and D) corrections signals representing in binary notation a number which is equal to

– 07 if the first (S) and the second signal (M) indicate that the syntheziser is mounted in an earth equipment utilized in the low band;

– 133 if the first (S) and the second signal (M) indicate that the syntheziser is mounted in an earth equipment and utilized in the high band;

– 70 if the first (S) and the second signal (M) indicate that the syntheziser is mounted in an equipment on bord.

2. Syntheziser according to claim 1, characterized in that the correction device (8) comprises:

– A band cutting circuit (9), the inputs of which receive the second signal (M) and the two channel selection signals (U and D) and the output of which furnishes a signal (B) indicating the low or the hig band;

– a processing circuit (10) for the first signal (S) and the band indication signal (B), the outputs of which furnish the correction signals constituted by tow correction numbers, the first for the units and the second for the decimals, each number being coded on four binary elements;

– a first adder circuit (11) which receives the first number (U1, U2, U3, U4) of the control unit (7) and the first correction number, and which furnishes corrected unit signals (u1, u2, u3, u4) to a first part of the inputs of the variable rate divider (3);

– a second adder circuit (12) which receives the second number (D1, D2, D3, D4) of the control unit (7), the second correction number and a carry-over signal issued by the first adder circuit (11) and which furnishes corrected decimal place signals (d1, d2, d3, d4) and a carry-over signal (r) to a second part of the inputs of the variable rate divider (3);

and that the variable rate divider (3) is constituted by:

– a frequency divider (27) having two fixed rates (ten and eleven), the input of which is connected to the output of the fixed rate divider (3),

– a first synchroneous counter (28) having four binary elements, the clock input of which is connected to the output of the frequency divider (27) having two fixed rates, the input A of this divider receiving the signal ($\overline{u1}$) issued by a first inverter (31) wihich receives the first corrected unit signal (u1) issued by the correction device (8), the input B receiving the signal ($\overline{u2}$) issued by a second inverter (32) which receives the second corrected unit signal (u2), the input C receiving the third corrected unit signal (u3), the input D receiving the signal issued by a logic «NOT OR» gate (33), the inputs of which receive respectively the third (u3) and the fourth (u4) corrected unit signal, and the count validation input (P) being connected to the carry-over output CO via a third inverter (34), the carry-over output being also connected to the rate control input (P) of the frequency divider (27) having two fixed rates,

– a second counter (29), the clock input of which is connected to the output of the frequency divider (27) having two fixed rates, the inputs A, B, C, D, of this divider receiving respectively the signals $\overline{d1}$, $\overline{d2}$, $\overline{d3}$, $\overline{d4}$) issued respectively by a fourth, a fifth, a sixth and a seventh inverter (34, 35, 36, 37), the inputs of which receive the corrected signals (d1, d2, d3, d4) of the decimal place issued by the correction device (8),

– a third counter (30), the clock input of which is connected to the output of the frequency divider (27) having two fixed rates, the input A of this divider receiving the carry-over signal (r) issued by the correction device (8), the input B receiving the signal ($\overline{r}$) issued by an eigth inverter (40) which receives at the input the signal (r), the input C being at a logical level «0», the input D being at the logical level «1» and the count validation input T being connected to the carry-over output CO of the second counter (29),

– a logic gate «NOT AND» 39 with three inputs, two of which are connected to the outputs QC and QD respectively of the second counter (29), whereas the third input is connected to the output of a nineth inverter (40), the input of which is connected to the output QD of the third counter (30) and the output of which is connected on one hand to the charge input L of each of the three counters (28, 29, 30) and on the other hand to the phase comparator (4).

3. Frequency syntheziser according to claim 2, characterized in that the band cutting circuit (9) comprises:

– a logic gate «NOT OR» (13), one input of which receives the signal U3 and the other input receives the signal D1,

– a first logic «NOT AND» gate (14), one input of which is connected to the output of the «NOT OR» gate and the other input is connected to the output of a first inverter (15) which receives the signal U4,

– a second logic «NOT AND» gate (16) having three inputs, one of which is connected to the output of the first «NOT AND» gate (14) and the two other inputs receive the signals D1 and D3 respectively,

– a third logic «NOT AND» gate (17), one input of which is connected to the output of the second «NOT AND» gate (16) and the other input is connected to the output of a second inverter (18) which receives the signal D4,

– a logic «EXCLUSIVE OR» gate (19), one input of which is connected to the output of the third «NOT AND» gate (17), the other input of which receives the second signal (M) indicating the operation mode and the output of which furnishes the band indication signal (B).

4. Frequency syntheziser according to claim 3, characterized in that the processing circuit (10) comprises:

– a first inverter (21), the input of which receives the first signal (S) indicating the type of utilization,

– a first «NOT OR» gate (20), one of the inputs of which is connected to the output of the first inverter and the other input is connected to the output of the band cutting circuit,

– a second inverter (22), the input of which is connected to the output of the first «NOT OR» gate (20),

– a third inverter (24), the input of which is connected to the output of the band cutting circuit,

– a second «NOT OR» gate (23), one input of which is connected to the output of the first inverter (21) and the other input is connected to the output of the third inverter (24, and that the first adder circuit (11) is constituted by:

– a binary adder (25) for adding two numbers of four binary elements each, the inputs A1, A2, A3, A4 of which receive the outputs U1, U2, U3, U4 respectively, the inputs B1 and B2 receive the signal (S) indicating the type of utilization, the input B3 receives the output signal of the first «NOT OR» gate (20) of the processing circuit and the input B4 is at the logical level «0»,

– a converter (26) from the binary code to the «BCD» code, the first, second and third inputs of which are connected to the second, third and fourth output respectively of the adder (25), the fourth input is connected to the carry-over output of that adder (25) and the first, second and third outputs furnish the second (u2), third (u3) and fourth (u4) corrected unit signals respectively, the first signal (u1) being furnished directly by the first output of the adder (25),

and that the second adder circuit (12) is constituted by a binary adder (12) for adding two numbers of four binary elements the inputs A1, A2, A3, A4 of which receive the signals D1, D2, D3, D4 respectively, the inputs B1 and B3 receive the output signal of the second inverter (22) of the processing circuit (10), the input B2 receives the output signal of the first inverter (21) of the processing circuit (10), the input B4 receives the output signal of the second «NOT OR» gate (23) of this same processing circuit (10), the carry-over input CO is connected to the fourth output of the converter (26) for converting the binary code into the «BCD» code, and the four outputs furnish the corrected signals (d1, d2, d3, d4) of the decimal place, the carry-over signal (r) being furnished by the carry-over output C4 of said adder (12).

Fig.1

Fig.2

Fig.3

Fig. 4

0 035 920

4/4